(19) **Europäisches Patentamt**

**European Patent Office**

**Office européen des brevets**

(11) **EP 1 260 039 B1**

(12) **EUROPEAN PATENT SPECIFICATION**

(45) Date of publication and mention
of the grant of the patent:
**11.01.2006 Bulletin 2006/02**

(51) Int Cl.:
*H04B 10/155* (2006.01)    *H03M 3/02* (2006.01)
*H04N 7/22* (2006.01)

(21) Application number: **01924102.5**

(22) Date of filing: **28.02.2001**

(86) International application number:
**PCT/US2001/006366**

(87) International publication number:
**WO 2001/065732 (07.09.2001 Gazette 2001/36)**

(54) **APPLICATION OF DIGITAL PROCESSING SCHEME FOR ENHANCED CABLE TELEVISION NETWORK PERFORMANCE**

ANWENDUNG EINES DIGITALEN VERARBEITUNGSSCHEMAS FÜR VERBESSERTE KABELFERNSEHENNETZWERKLEISTUNG

APPLICATION D'UN SCHEMA DE TRAITEMENT NUMERIQUE PERMETTANT D'AMELIORER LES PERFORMANCES D'UN RESEAU DE TELEVISION PAR CABLE

(84) Designated Contracting States:
**DE ES FR GB NL**

(30) Priority: **29.02.2000 US 185959 P**

(43) Date of publication of application:
**27.11.2002 Bulletin 2002/48**

(73) Proprietor: **GENERAL INSTRUMENT CORPORATION**
**Horsham,**
**Pennsylvania 19044 (US)**

(72) Inventor: **HOWALD, Robert, L.**
**Chalfont, PA 18914 (US)**

(74) Representative: **Bohnenberger, Johannes et al**
**Meissner, Bolte & Partner**
**Widenmayerstrasse 48**
**80538 München (DE)**

(56) References cited:
**WO-A-82/04508**        **US-A- 5 892 865**
**US-A- 6 020 838**

**Description**

CROSS-REFERENCE TO RELATED APPLICATIONS

The present invention is related to an invention that is the subject matter of a commonly-assigned co-pending application entitled "HFC Return Path System Using Digital Conversion and Transport" filed on April 21, 2000 and assigned Serial No. 09/556,731, which is hereby incorporated by reference.

FIELD OF THE INVENTION

The present invention relates generally to improving cable television hybrid-fiber-coax (CATV HFC) network performance, and more particularly to the application of digital signal processing techniques for improved performance of the HFC return path using digital return solutions.

BACKGROUND OF THE INVENTION

Hybrid Fiber-Coax (HFC) cable television (CATV) systems have evolved into two-way digital networks within the last decade. Essentially a network headend transmits signals to a plurality of remote points in a first, "forward" or "downstream" direction. Signals are transmitted from the remote points to the headend in a second, "reverse" or "upstream" direction. In the reverse path, the transport systems as well as the information payload has become digital in nature, evolving from linear optics moving the return spectrum from fiber optic nodes to processing centers, to baseband digital transport systems.

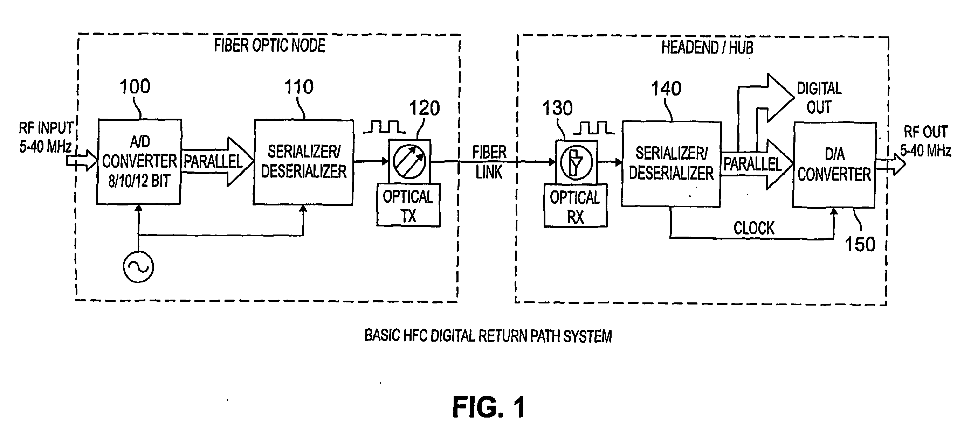

FIGURE 1 shows a block diagram of such a system. The system of FIGURE 1 is described in detail under separate disclosure as noted above under Cross-Reference to Related Applications. Essentially, the return path signal from the fiber optic node to the headend is represented by encoding it entirely as ones and zeroes. Specifically, the composite return path waveform is converted to a sequence of digital words whose value represent analog signal samples (A/D 100), the digital words are arranged into a serial stream with appropriate synchronization information (Serializer/Deserializer 110), and the electrical digital signal is converted into an optical digital signal and transmitted across the optical fiber (Optical TX 120). The optical path carries the signals to the headend which has the proper components for receiving and processing the optical signals, i.e., the process is inverted at the receive side (Optical RX 130, Serializer/Deserializer 140, D/A 150). The use of this digital optical technology provides many key advantages compared to traditional analog systems. Among these are longer distance capability, performance insensitivity to length, environmental robustness, cost benefits, and interface flexibility.

The performance of digital return links can be compared favorably to their analog counterparts. Additionally, the performance can be flexibly traded off against bandwidth. This occurs by noting that less Analog-to-Digital (A/D) converter bits of resolution used set the signal-to-noise ratio (SNR) for the signal being transported. Less bits to transport means lower SNR, but also a lower data rate. More bits means a higher SNR at 6 dB/bit. As such, it is advantageous to find ways to improve the SNR after A/D conversion for lower resolution conversions. If the SNR can be increased by signal processing, a lower number of bits of transport can be used to meet a given SNR compared to the basic digital return system in FIGURE 1. Such an approach fits broadly into the category of noise shaping technology.

Improvement of CATV return path performance using cost effective technologies is a primary issue in deploying reliable network architectures for HFC. In this regard, there is continued progress in the performance and speed of state-of-the-art analog-to-digital converter (A/D) integrated circuit (IC) manufacturers. However, while it is straightforward to obtain a reasonable SNR at the receive end with high-speed off-the-shelf A/D technology available today, HFC architecture design involves more complexity than this single point-to-point example. In practical hub and Headend environments, it is typically the case that received inputs from topologically diverse nodes are combined (RF summed) at the Headend. Each such combine entails a noise penalty of 3 dB, or effectively decreases the resolution of the A/D system by one-half of a bit. In essence, a system designed with 10-bit A/D converter in the field, and combined four ways at the Headend, has the theoretical performance of an 8-bit system. Similarly, if it is desired for the end-of-line performance to have ten bits of resolution after a four way combine, then the conversion process must begin with 12 bits of theoretical performance at each node.

WO 8204508 discusses the use of an enhanced sigma-delta modulation encoder for enhanced encoding of a digital signal. US-A-5892865 discusses the suppression of noise and undesirable energy in a bidirectional communication network. Neither of these documents discloses, however, a method of increasing the performance of the hybrid-fibre-coax return path without resorting to expensive higher resolution A/D converters, by implementing a digital signal processing approach.

The present invention is therefore directed to improving the performance of a CATV HFC baseband digital optical transmission return path using cost effective digital solutions.

**EP 1 260 039 B1**

SUMMARY OF THE INVENTION

A system for improving the performance of the HFC return path according to the present invention implements a DSP approach to increase the signal-to-noise ratio (SNR), thereby improving the performance of the HFC return path without resorting to higher resolution A/D converters. The approach uses well-known signal processing architectures applied to an RF system to achieve in-band quantization noise reduction. The technique is applicable to any HFC return architecture that uses a baseband digital optical transmission in the reverse path implementation.

One exemplary embodiment of the present invention includes a system and method for increasing the performance of a digital return path in a hybrid-fiber-coax television system using baseband serial optical transport, receives an analog composite return path waveform at a comparator input to a digital return transmitter that includes an A/D converter and a first nonlinear processor. A first processing function is applied to a signal output from the comparator at the first nonlinear processor and the processed signal is forwarded to the A/D converter which converts the processed signal to generate a quantized output signal of a sequence of digital words whose value represent analog signal samples. The quantized digital signal is output to an output of the digital return transmitter and to a feedback loop including a D/A converter, which converts the quantized digital signal to an analog feedback signal and forwards the analog feedback signal to a second processor. The second processor applies a second processing function to the analog feedback signal and outputs the processed analog feedback signal to the comparator input of the digital return transmitter. The comparator input to the digital return transmitter adds the processed analog feedback signal to the analog composite return path waveform to create the signal output from the comparator.

The quantized output of the digital words are arranged into a serial stream along with appropriate synchronisation information which is used to identify the boundaries between the words and to recover the timing of the bits themselves. The electrical digital signal is then converted to an optical digital signal and the optical ones and zeros are transmitted across an optical fibre. At the receiving side, these steps are reversed.

BRIEF DESCRIPTION OF THE DRAWINGS

The above-mentioned and other objects, features and advantages of the present invention will become more apparent from the following detailed description when taken in conjunction with the accompanying drawings, wherein:

FIGURE 1 depicts the basic elements of a hybrid fiber-coax digital return path transport system.
FIGURE 2 depicts a simplified block diagram of a digital return transmitter with nonlinear processor.
FIGURE 3 illustrates the quantization noise spectrum of an A/D converter with noise-like input.
FIGURE 4 illustrates the shaped quantization noise spectrum vs. unprocessed quantization noise spectrum.
FIGURE 5 graphs the rms noise vs oversampling ratio and illustrates the effect of nonlinear feedback on quantization noise performance.
FIGURE 6 depicts a simplified block diagram of a first sigma-delta A/D converter including a first order modulator and a digital decimator.

DETAILED DESCRIPTION

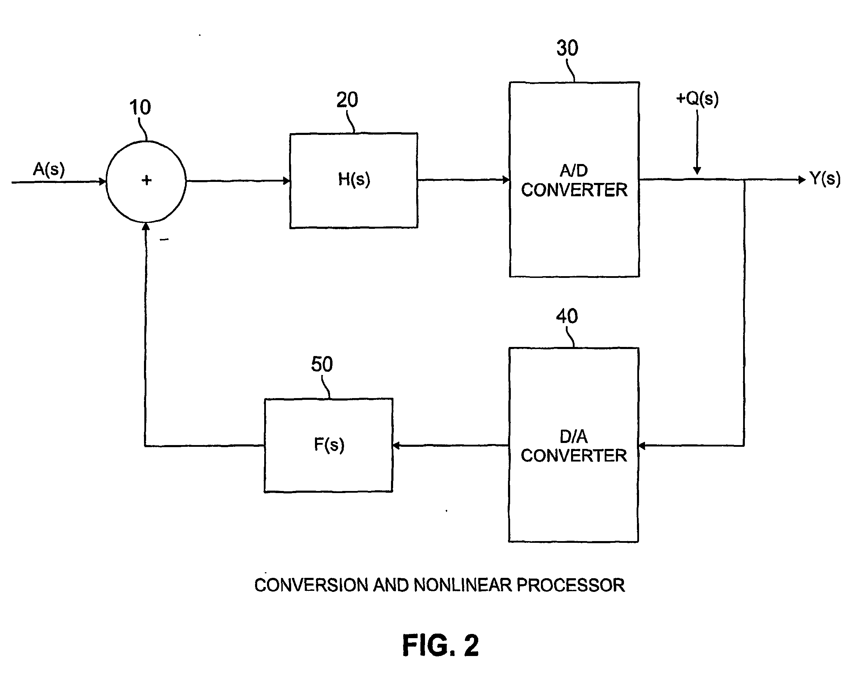

The basic elements of the proposed system for improved return path performance for digital communication signals are shown in FIGURE 2 which shows an example topology of an A/D converter with additional functional block diagrams which perform digital signal processing (DSP) algorithms designed to improve the SNR compared to a system that does not perform the processing functions. Implemented in the DSP is a nonlinear method, used in high-performance applications such as audio processing, that create this improvement. The system shown in FIGURE 2 illustrates a processor and A/D converter in which an analog input signal A(s) is input to a comparator 10, the output of which is coupled to a nonlinear processor H(s) 20, the output of which is coupled to A/D converter 30. In a feedback loop, the output of A/D converter 30 is coupled to a D/A converter 40 and processor F(s) 50 in the feedback loop to the input comparator 10. Essentially, the input to the circuit is fed to the quantizer via the nonlinear processor, and the quantized output is fed back through D/A converter 40 which converts each sample of the digital signal to generate the analog feedback signal which is coupled and subtracted from the input, forcing the average value of the quantized signal to track the average input.

Those skilled in the art will appreciate that implementation of this type of converter is generally based on low-frequency implementations, such as for high-fidelity audio. Additionally, the quantization level is typically of lower resolution due to the ability to implement DSP more effectively at the low speeds typically used. For the CATV application, the implementation of the DSP algorithms is significantly increased in complexity and design due to the nature of the high speed processing necessary.

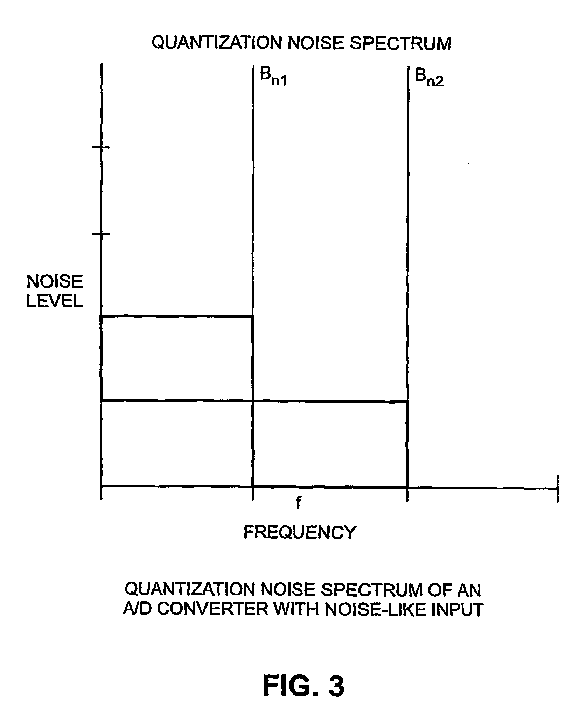

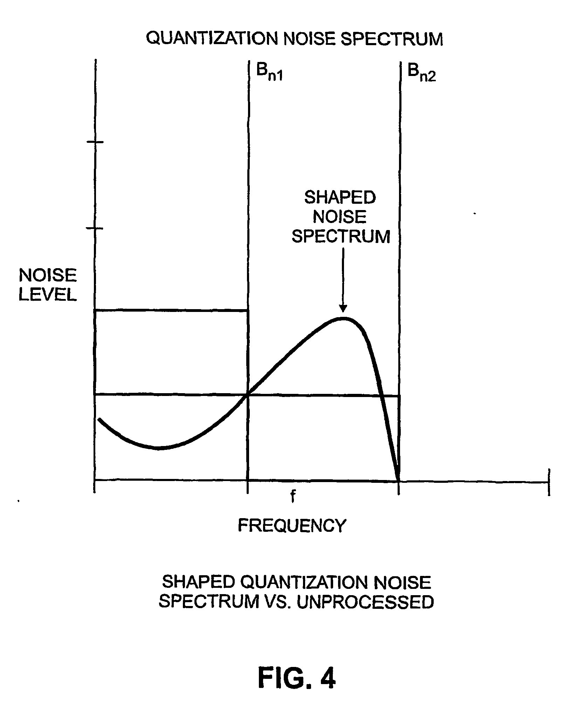

With reference to FIGURES 3 and 4, the operation of the processor is discussed and the nature of the improvement provided by the implementation of the converter in the digital return transmitter is graphically shown. The quantization noise spectrum of the output of an A/D converter is shown in FIGURE 3. The reverse path bandwidth is assumed identical to the Nyquist bandwidth at the A/D output $B_{n1}$. As can be seen, the noise spectrum is modeled as flat over the Nyquist bandwidth of the converter. FIGURE 3 shows a sampled output spectrum with typical relationships between the three parameters above. The higher the clock frequency is relative to the reverse path bandwidth $B_{n1}$, the lower the spectral density becomes, providing a means to lower the noise power in the reverse bandwidth. FIGURE 3 shows this example where the clock frequency is increased, going from $B_{n1}$ to $B_{n2}$, and lowering the spectral density. In other words, the same amount of noise power, determined by the resolution of the A/D, is spread over a wider Nyquist bandwidth.

This "oversampling" technique illustrated with reference to FIGURE 3 is an inefficient way to obtain noise reduction, as the clock rate must be doubled to achieve only 3 dB of SNR improvement. Additionally, the digital reverse system for HFC is already implementing A/D converters that are operated at state of the art clock rates. It is not possible in commercial devices to increase the clock rate enough for major performance gains without suffering severe degradation or rendering the part completely nonfunctional.

Instead of relying on oversampling alone to provide the increase in SNR, FIGURE 2 shows a diagram of a nonlinear processor, H(s) which implements a transfer function that provides this capability. Also, processor F(s) in the feedback loop may provide additional filtering as needed. Both H(s) and F(s) can take on many topologies, depending on improvement desired and complexity of implementation. The nonlinear nature however makes precise analysis difficult, especially when higher order architectures are used. In many cases behavior may only characterized through simulations.

An exemplary resulting noise spectrum from such a processor is shown in FIGURE 4. In this case, the spectrum, which previously had a uniform density (white) out to $B_n$, is no longer flat. The noise power between the uniform density and nonuniform density is the same, but in the latter case, the power is shifted into the region of spectrum between $B_{n1}$ and $B_{n2}$. That is, the modulator 'shapes' the quantization noise so that most of the energy will be above the signal bandwidth. Since the reverse system bandwidth is $B_{n1}$, the region which now contains the bulk of the noise power can be filtered with no effect on the desired signal. With much of the noise now shifted into this region, the noise power within the signaling band has been reduced. This reduction of noise power is equivalent to the effect of using a higher resolution A/D converter in that region of the sampled spectrum. Since the region of the sampled spectrum in which noise reduction occurs is the only one of concern, this technique essentially provides an effective bit increase proportional to the drop in noise power within $B_{n1}$. In a representative example of what can be expected, SNR improvements of 20 dB can be achieved, which corresponds to over three bits of additional resolution. The exact gain is highly dependent upon amount of oversampling and the architecture of the nonlinear processor.

Mathematically, the noise reduction analysis can be expressed, in the most simplistic case, using FIGURE 2 as a guide. Assume that F(s) = 1. For quantized output Y(s), quantization noise Q(s), analog input A(s), and lowpass, high gain, processing transfer function H(s), the diagram shows the following:

$$Y(s) = [A(s) - Y(s)]\, H(s) + Q(s) \qquad (1)$$

$$Y(s) + Y(s)\, H(s) = A(s)\, H(s) + Q(s) \qquad (2)$$

$$Y(s) = \{A(s)\, H(s)\, /\, [1+H(s)]\} + \{Q(s)\, /\, [1+H(s)]\} \qquad (3)$$

Then, assuming over the bandwidth of interest of the input that $|H(s)| \gg 1$, (3) becomes

$$Y(s) = A(s) + Q(s)/H(s) \qquad (4)$$

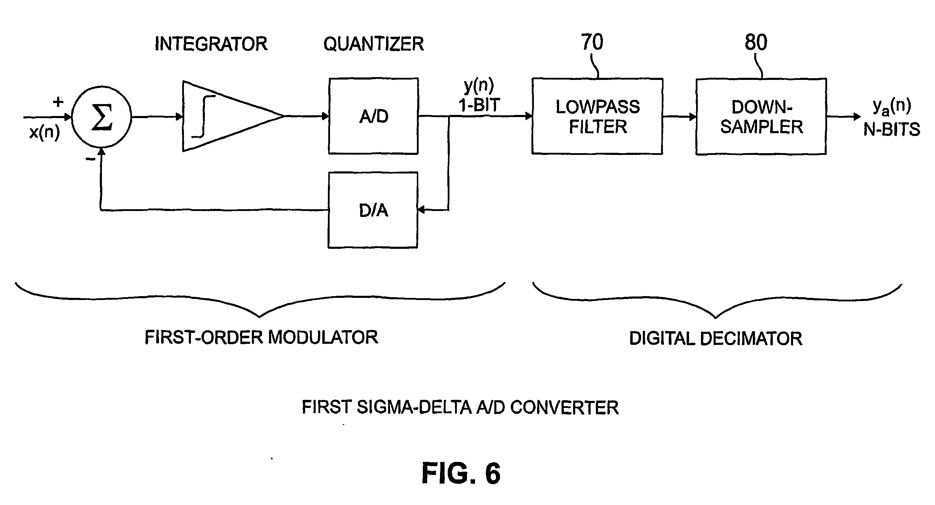

Because $|H(s)| \gg 1$, the last term can be small. The quantization noise spectral density, Q(s), is reduced by the magnitude of H(s) in the signal bandwidth. However, outside the signal bandwidth, the spectral density is increased. Of course, this part of the spectrum is of no interest. However, in order to make proper use of the shift in spectral energy to the high end of the band, digital filtering is done after the quantization process to reduce noise power (i.e. noise enhanced during the conversion process can be controlled very effectively). As illustrated in FIGURE 6, which shows a first sigma delta A/D converter coupled to a digital decimator, a digital lowpass filtering stage (lowpass filter 70) may be implemented to smooth the output of the digital modulator, greatly attenuating out-of-band quantization noise, interference and high frequency components of the signal. Also, if desired, downsampling (downsampler 80) can be implemented to bring the sampled signal to the Nyquist rate.

As an example, consider an 8-bit A/D converter. This number is chosen because it has practical implication in terms of both performance and speed for the HFC application. Today, a good off-the-shelf 8-bit device samples at roughly 200 MHz, providing roughly a two-times oversampling for HFC return paths. Within another year, the high-end parts available now that go faster will be available in volume and at low cost, suitable for CATV applications. A four-times oversampling will be easily within reach.

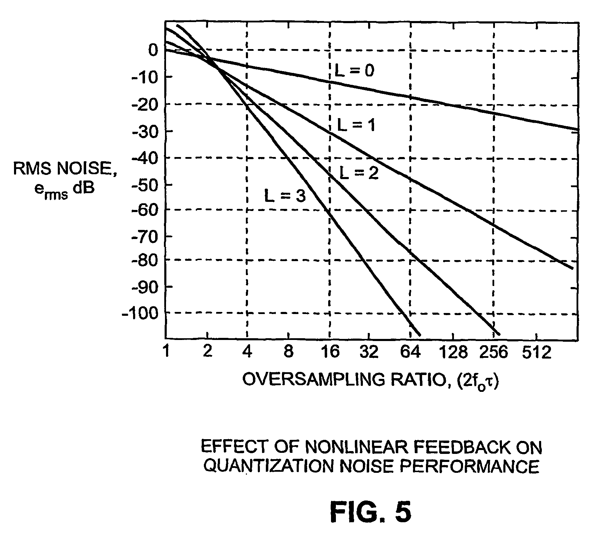

FIGURE 5 plots the in-band noise against the oversampling ratio for examples of PCM and one, two and three feedback loops. Referring to FIGURE 5, it can be seen that a four-times oversampling with a second order feedback system provides roughly 20 dB of additional in-band quantization noise reduction. At 6 dB/bit, this represents more than three bits of effective resolution, turning a 7.5-bit conversion process (an 8-bit non-ideal A/D converter) into nearly eleven bits of effective resolution. This represents performance essentially better than any analog return technology in widespread use today, such as linear DFB laser transmitters. Additionally, unlike the linear optics case, the performance is distant-independent.

In terms of implementation, architectures such as those above where F(s)=1, which represent delta-sigma modulation, are well suited to digital design technologies, such as FPGA's and custom ASIC design. However, the clock rates required to achieve the necessary oversampling ratio are relatively high for commercial FPGA implementation in today's technology. Custom IC developments have created chips capable of these processing rates. It is anticipated that the commercial FPGA hurdle also will be cleared in the near future as development continues.

The above describes a DSP approach to increasing the performance of the HFC return path without resorting to higher resolution A/D converters. The approach uses well-known signal processing architectures applied to an RF system to achieve in-band quantization noise reduction. The individual components are known and widely available. The technique is applicable to any HFC return architecture which uses a baseband digital optical transmission in the reverse path implementation.

Referring once again to FIGURE 2, processor F(s), like processor H(s), can take on any variety of transfer function responses to serve application performance requirements. Furthermore, this exemplary modification should not be interpreted to limit the modifications and variations of the invention covered by the claims but are merely illustrative of possible variations.

## Claims

1. A method for increasing the performance of a digital return path in a hybrid-fiber-coax television system using baseband serial optical transport, wherein said method is performed at a fiber optic node, said method comprising the steps of:

   receiving an analog composite return path waveform A(s) at a comparator input (10) to a digital return transmitter that includes an A/D converter (30) and a first nonlinear processor (20);
   applying a first processing function H(s) to a signal output from the comparator (10) at the first nonlinear processor (20) and forwarding the processed signal to the A/D converter (30);
   converting the processed signal to generate a quantized output signal Q(s) of a sequence of digital words whose value represent analog signal samples;
   outputting the quantized digital signal to an output of the digital return transmitter and to a feedback loop including a D/A converter (40);
   converting the quantized digital signal to an analog feedback signal and forwarding the analog feedback signal to a second processor (50);
   applying a second processing function F(s) to the analog feedback signal and outputting the processed analog feedback signal to the comparator input (10) of the digital return transmitter,
   wherein the comparator input (10) to the digital return transmitter adds the processed analog feedback signal to the analog composite return path waveform to create the signal output from the comparator (10);
   **characterized by**:

   arranging the quantized output of said digital words into a serial stream with appropriate synchronization information to identify the boundaries between words and to recover timing of the bits themselves;
   converting the electrical digital signal to an optical digital signal, and transmitting the optical ones and zeros across an optical fiber; and

inverting the foregoing steps at the receive side.

2. A method according to Claim 1, further comprising the step of lowpass filtering the quantized digital signal.

3. A method according to claim 2, further comprising the step of downsampling the filtered quantized digital signal.

4. A method according to claim 3, wherein the filtered quantized digital signal is downsampled to the Nyquist rate.

5. A method according to claim 1, wherein the second processing function is equal to one and said digit return transmitter represents a delta sigma modulator.

6. A method according to claim 5, wherein the average value of the quantized digital signal tracks an average processed analog feedback signal.

**Patentansprüche**

1. Ein Verfahren zum Steigern der Leistung einer digitalen Rückleitung in einem Hybrid-Faser-Koax-Fernsehsystem unter Verwendung von serieller optischer Basisbandübertragung, wobei das Verfahren an einem Glasfaserknoten durchgeführt wird, wobei das Verfahren die folgenden Schritte umfasst:

Empfangen einer analogen zusammengesetzten Rückleitungswellenform A(s) an einem Komparatoreingang (10) an einen digitalen Rücksender, der einen A/D-Wandler (30) und einen ersten nichtlinearen Prozessor (20) einschließt;
Anwenden einer ersten Verarbeitungsfunktion H(s) an einen Signalausgang von dem Komparator (10) an dem ersten nichtlinearen Prozessor (20) und Weiterleiten des verarbeiteten Signals an den A/D-Wandler (30);
Umwandeln des verarbeiteten Signals, um ein quantisiertes Ausgangssignal Q(s) einer Sequenz digitaler Wörter zu erzeugen, deren Wert analoge Signalproben darstellt;
Ausgeben des quantisierten digitalen Signals an einen Ausgang des digitalen Rücksenders und an eine Rückkopplungsschleife, die einen D/A-Wandlers (40) einschließt;
Umwandeln des quantisierten digitalen Signals in ein analoges Rückkopplungssignal und Weiterleiten des analogen Rückkopplungssignals an einen zweiten Prozessor (50);
Anwenden einer zweiten Verarbeitungsfuktion F(s) auf das analoge Rückkopplungssignal und Ausgeben des verarbeiteten analogen Rückkopplungssignals an den Komparatoreingang (10) des digitalen Rücksenders, wobei der Komparatoreingang (10) zu dem digitalen Rücksender das verarbeitete analoge Rückkopplungssignal zu der analogen zusammengesetzten Rückleitungswellenform hinzufügt, um den Signalausgang von dem Komparator (10) zu erstellen,
**gekennzeichnet durch**:

Anordnen des quantisierten Ausgangs der digitalen Wörter in einen seriellen Strom mit angemessenen Synchronisationsinformationen, um die Grenzen zwischen Wörtern zu ermitteln und die Taktung der Bits selbst wiederherzustellen;
Umwandeln des elektrischen digitalen Signals in ein optisches digitales Signal, und Senden der optischen Einser und Nullen über einen Lichtwellenleiter; und
Invertieren der vorangehenden Schritte an der Empfangsseite.

2. Verfahren gemäß Anspruch 1, das ferner den Schritt des Tiefpassfilterns des quantisierten digitalen Signals umfasst.

3. Verfahren gemäß Anspruch 2, das ferner den Schritt des Downsamplings des gefilterten quantisierten digitalen Signals umfasst.

4. Verfahren gemäß Anspruch 3, wobei das gefilterte quantisierte digitale Signal auf die Nyquist-Rate downgesampelt wird.

5. Verfahren gemäß Anspruch 1, wobei die zweite Verarbeitungsfunktion gleich Eins ist und der digitale Rücksender einen Delta-Sigma-Modulator darstellt.

6. Verfahren gemäß Anspruch 5, wobei der Durchschnittswert des quantisierten digitalen Signals einem durchschnittlichen verarbeiteten analogen Rückkopplungssignal folgt.

## Revendications

**1.** Une méthode destinée à augmenter la performance d'un chemin de retour numérique dans un système de télévision hybride fibre et coaxial en utilisant un transport optique en série de bande de base, dans laquelle ladite méthode est effectuée au niveau d'un noeud de fibre optique, ladite méthode comportant les étapes de :

recevoir une forme d'onde de chemin de retour composite analogique A(s) au niveau d'une entrée de comparateur (10) dans un émetteur de retour numérique qui comprend un convertisseur AIN (30) et un premier processeur non linéaire (20) ;

appliquer une première fonction de traitement H(s) à une sortie de signal du comparateur (10) au niveau du premier processeur non linéaire (20) et acheminer le signal traité jusqu'au convertisseur AIN (30) ;

convertir le signal traité pour générer un signal de sortie quantifié Q(s) d'une séquence de mots numériques dont la valeur représente des échantillons de signal analogique ;

sortir le signal numérique quantifié dans une sortie de l'émetteur de retour numérique et dans une boucle de rétroaction comprenant un convertisseur A/N (40) ;

convertir le signal numérique quantifié en un signal de rétroaction analogique et acheminer le signal de rétroaction analogique jusqu'à un deuxième processeur (50) ;

appliquer une deuxième fonction de traitement F(s) au signal de rétroaction analogique et sortir le signal de rétroaction analogique traité dans l'entrée de comparateur (10) de l'émetteur de retour numérique,

dans laquelle l'entrée de comparateur (10) dans l'émetteur de retour numérique ajoute le signal de rétroaction analogique traité à la forme d'onde de chemin de retour composite analogique pour créer la sortie de signal du comparateur (10) ;

**caractérisée par** :

adapter la sortie quantifiée desdits mots numériques en un flux en série ayant des informations de synchronisation appropriées pour identifier les limites entre les mots et pour récupérer le rythme des bits eux-mêmes ;

convertir le signal numérique électrique en un signal numérique optique, et transmettre les uns et zéros optiques sur une fibre optique ; et

inverser les étapes précédentes au niveau du côté réception.

**2.** Une méthode selon la revendication 1, comportant de plus l'étape de filtrer par filtre passe-bas le signal numérique quantifié.

**3.** Une méthode selon la revendication 2, comportant de plus l'étape de sous-échantillonner le signal numérique quantifié filtré.

**4.** Une méthode selon la revendication 3, dans laquelle le signal numérique quantifié filtré est sous-échantillonné au taux de Nyquist.

**5.** Une méthode selon la revendication 1, dans laquelle la deuxième fonction de traitement est égale à un et ledit émetteur de retour numérique représente un modulateur delta sigma.

**6.** Une méthode selon la revendication 5, dans laquelle la valeur moyenne du signal numérique quantifié suit un signal de rétroaction analogique traité moyen.

BASIC HFC DIGITAL RETURN PATH SYSTEM

**FIG. 1**

EP 1 260 039 B1

CONVERSION AND NONLINEAR PROCESSOR

**FIG. 2**

EP 1 260 039 B1

QUANTIZATION NOISE SPECTRUM

QUANTIZATION NOISE SPECTRUM OF AN
A/D CONVERTER WITH NOISE-LIKE INPUT

FIG. 3

QUANTIZATION NOISE SPECTRUM

SHAPED QUANTIZATION NOISE
SPECTRUM VS. UNPROCESSED

# FIG. 4

EFFECT OF NONLINEAR FEEDBACK ON
QUANTIZATION NOISE PERFORMANCE

## FIG. 5

INTEGRATOR    QUANTIZER         70              80

x(n) → [+ − Σ] → [∫ INTEGRATOR] → [A/D] → y(n) 1-BIT → [LOWPASS FILTER] → [DOWN-SAMPLER] → $y_a(n)$ N-BITS

[D/A]

FIRST-ORDER MODULATOR          DIGITAL DECIMATOR

FIRST SIGMA-DELTA A/D CONVERTER

**FIG. 6**

EP 1 260 039 B1